# EUROPÄISCHE PATENTSCHRIFT

(11) **EP 1 449 263 B1**
(45) Veröffentlichungstag und Bekanntmachung des Hinweises auf die Patenterteilung: **16.04.2008**
(21) Anmeldenummer: 02804152.3
(22) Anmeldetag: 02.12.2002
(51) Int. Cl.: H01L 33/00, H01L 25/075

(54) **OPTOELEKTRONISCHES BAUELEMENT**
OPTOELECTRONIC COMPONENT
COMPOSANT OPTOELECTRONIQUE

(30) Priorität: 30.11.2001 DE 10158753; 11.09.2002 DE 10241989
(43) Veröffentlichungstag der Anmeldung: 25.08.2004
(73) Patentinhaber: OSRAM Opto Semiconductors GmbH, 93055 Regensburg (DE)
(72) Erfinder: ARNDT, Karlheinz, 93059 Regensburg (DE); FARCHTCHIAN, Nadir, 10589 Berlin (DE)
(74) Vertreter: Epping - Hermann - Fischer
(86) Internationale Anmeldenummer: PCT/DE2002/004404
(87) Internationale Veröffentlichungsnummer: WO 2003/049204

(56) Entgegenhaltungen:
- EP-A- 1 249 874
- WO-A-00/55914
- WO-A-98/12757
- DE-A- 2 457 572
- DE-A- 2 509 047
- US-A- 3 875 456
- US-A- 4 152 624
- US-A- 5 656 847
- US-A1- 2001 026 011
- PATENT ABSTRACTS OF JAPAN vol. 2000, no. 09, 13. Oktober 2000 (2000-10-13) & JP 2000 156525 A (KYOTO DENKIKI KK), 6. Juni 2000 (2000-06-06)
- PATENT ABSTRACTS OF JAPAN vol. 014, no. 553 (E-1010), 7. Dezember 1990 (1990-12-07) -& JP 02 238680 A (SANYO ELECTRIC CO), 20. September 1990 (1990-09-20)
- PATENT ABSTRACTS OF JAPAN vol. 011, no. 171 (E-512), 2. Juni 1987 (1987-06-02) & JP 62 004380 A (TOSHIBA CORP), 10. Januar 1987 (1987-01-10)

## Beschreibung

Die Erfindung betrifft ein optoelektronisches Bauelement, insbesondere ein oberflächenmontierbares optoelektronisches Bauelement, nach dem Oberbegriff von Patentanspruch 1.

Bei herkömmlichen oberflächenmontierbaren optoelektronischen Bauelementen wird zunächst ein vorgehäustes Bauteil dadurch hergestellt, dass ein vorgefertigter Leiterrahmen (Leadframe) mit einem geeigneten Kunststoffmaterial umspritzt wird, welches das Gehäuse des Bauteils bildet. Dieses Bauteil weist zum Beispiel an der Oberseite eine Vertiefung bzw. Ausnehmung auf, in die von zwei gegenüberliegenden Seiten Leadframe-Anschlüsse eingeführt sind, wobei auf einem ein Halbleiterchip wie beispielsweise ein LED-Chip aufgeklebt und elektrisch kontaktiert wird. In diese Ausnehmung wird dann eine klare strahlungsdurchlässige Vergussmasse eingefüllt. Diese Grundform von oberflächenmontierbaren optoelektronischen Bauelementen ist beispielsweise aus dem Artikel "SIEMENS SMT-TOPLED für die Oberflächenmontage" von F. Möllmer und G. Waitl, Siemens Components 29 (1991), Heft 4, Seiten 147-149, bekannt.

Die Druckschrift WO 98/12757 A beschreibt ein Halbleiterbauelement mit einer wellenlängenkonvertierenden Vergussmasse.

Die Druckschrift JP2000 156525 A beschreibt eine Beleuchtungseinrichtung mit einer Vielzahl von Leuchtdioden.

Die Druckschrift US 4,152,624 A beschreibt eine Leuchtdiode mit einem vergossenen Leuchtdiodenchip.

Die Druckschrift JP 02 0238680 A beschreibt eine Vielfarben-Leuchtdiode.

Die Druckschrift DE 25 09 047 A beschreibt eine Leuchtdiode.

Die Druckschrift US 5,656,847 A beschreibt eine Leuchtdiodenanordnung sowie eine Display mit Leuchtdioden.

Bei diesen bekannten oberflächenmontierbaren Bauformen kann eine sehr gerichtete Abstrahlung dadurch erreicht werden, dass die durch das Kunststoffgehäuse gebildeten Seitenwände als schräggestellte Reflektoren ausgebildet werden. Je nach Gehäuseform bzw. Reflektorform kann das Bauelement als sogenannter Toplooker, d.h. mit einer Hauptabstrahlrichtung im Wesentlichen senkrecht zur Montageebene des Bauelements, oder als sogenannter Sidelooker, d.h. mit einer Hauptabstrahlrichtung im wesentlichen parallel oder in einem spitzen Winkel zur Montageebene des Bauelements, konstruiert werden. Beispiele eines Toplookers und eines Sidelookers mit den entsprechenden Gehäuseformen sind zum Beispiel in FIG 2 bzw. FIG 3 der EP 0 400 175 A1 gezeigt.

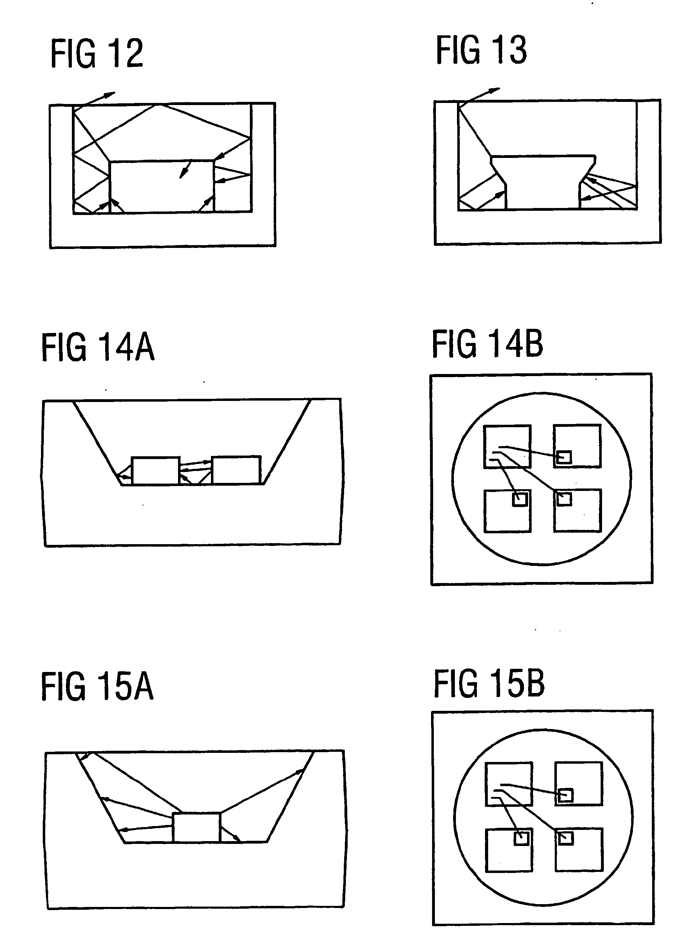

In den FIG 12 bis 15 sind verschiedene herkömmliche Bauformen von optoelektronischen Bauelementen der eingangs genannten Art schematisch dargestellt.

In dem Fall von FIG 12 ist der Halbleiterchip, wie beispielsweise ein LED-Chip, in einem engen Gehäuse bzw. Grundkörper eingebaut. In diesem Gehäuse, werden die von dem Halbleiterchip zur Seite ausgesandten Strahlen von den als Reflektoren ausgebildeten Seitenwänden des Grundkörpers wieder auf die Seitenflächen des Halbleiterchips zurückreflektiert und absorbiert, so dass dort Strahlung verloren geht.

Bei der in FIG 13 dargestellten Konstruktion eines herkömmlichen optoelektronischen Bauelements ist ein Lichtverlust im Bauelement insbesondere durch die spezielle Chiptechnologie bedingt, bei der ein großer Anteil der emittierten Strahlung von dem Halbleiterchip schräg nach hinten abgestrahlt wird. Diese schräg nach hinten ausgesandte Strahlung wird zu einem wesentlichen Teil vom Grundkörper absorbiert und geht verloren.

Die FIG 14A und 14B zeigen in Seitenansicht bzw. Draufsicht einen Grundkörper, in dem mehrere LED-Chips eingebaut sind, um zum Beispiel durch Mischen von drei Grundfarben beliebige Farben erzeugen zu können. In diesem Fall wird ein Teil der von den LED-Chips seitlich emittierten Strahlung von den Seitenflächen der benachbarten LED-Chips absorbiert, wodurch Strahlung verlorengeht.

Schließlich sind auch optoelektronische Bauelemente bekannt, deren Grundkörper dunkel ausgebildet ist, wie dies in FIG 15A veranschaulicht ist. Diese Ausführungsform wird beispielsweise eingesetzt, um einen möglichst guten Kontrast zwischen der Emissionsfläche des Bauelements und der übrigen Vorrichtungsfläche zu erzielen, wie dies in FIG 15B zu erkennen ist. Eine derartige Kontrastverbesserung findet zum Beispiel in der Anzeigen- oder Displaytechnik Verwendung. Das dunkle Gehäuse hat jedoch den Nachteil, dass ein gewisser Anteil des von dem LED-Chip emittierten Lichts an den dunklen Seitenwänden der Ausnehmung absorbiert wird wodurch die Lichtausbeute verringert wird.

Speziell bei Bauelementen mit mehreren LED-Chips, wie sie beispielsweise in FIG 14 gezeigt sind, ergibt sich zudem ein ungleichmäßiger und dezentriert wirkender Lichtaustritt aus der Emissionsfläche des Bauelements. Außerdem sind die mehreren LED-Chips notwendigerweise nicht alle zentriert angeordnet, so dass bei einer seitlichen Betrachtung des Bauelements die Lichtemissionen der einzelnen LED-Chips unterschiedlich stark ins Gewicht fallen können und damit zum Beispiel die Farbmischung bei Mehrfarben-LEDs ab einem gewissen Grad winkelabhängig wird.

Aufgrund der klaren strahlungsdruchlässigen Vergussmasse sind die LED-Chips und deren Verdrahtungen aus kurzen Entfernungen zum Teil differenzierbar. Insbesondere bei einer Verengung der Abstrahlcharakteristik zur Erzielung einer höheren Lichtstärke wird die Chipoberfläche auf die Emissionsfläche des Bauelements projiziert. Des weiteren ergibt sich bei Fremdlichteinfall ein mangelhafter Kontrast durch das an der Emissionsfläche und der Chipoberfläche reflektierte Fremdlicht.

Zur Vermeidung der oben genannten nachteiligen Erscheinungen wie geringer Wirkungsgrad, störende Projektionen der Chipoberflächen und Verdrahtungen, ungleichmäßige Lichtemission und Kontrastmangel werden derzeit zum Beispiel optoelektronische Bauelemente eingesetzt, welche einen höheren Wirkungsgrad durch höherwertige und damit auch kostenintensivere Chiptechnologien erreichen, bei denen insbesondere die LED-Chips hauptsächlich über die Chipoberfläche Licht emittieren.

Für Anwendungen im Bereich der Anzeigentechnik, bei denen ein guter Kontrast bei der Lichtemission wichtig ist, sind aus dem Stand der Technik einerseits eine dunkle Ausbildung der Bauelement-Oberfläche, wie sie in FIG 15B angedeutet ist, oder der Einsatz von vorgeschalteten Blendenvorrichtungen bekannt, um die LED-Chips gegen Fremdlichteinfall abzuschatten.

Ausgehend von dem vorgenannten Stand der Technik liegt der vorliegenden Erfindung die Aufgabe zugrunde, ein verbessertes optoelektronisches Bauelement der eingangs genannten Art zu entwickeln, das insbesondere mehr Licht nach vorne emittiert und bei dem vorzugsweise die oben genannten Nachteile von herkömmlichen Bauelementen weitestgehend beseitigt sind. Insbesondere soll mit dem optoelektronischen Bauelement eine gleichmäßigere Lichtemission und ein besserer Kontrast erzielt werden.

Diese Aufgabe wird durch ein optoelektronisches Bauelement mit den Merkmalen von Patentanspruch 1 gelöst. Vorteilhafte Weiterbildungen und Ausführungsformen der Erfindung sind Gegenstand der abhängigen Ansprüche 2 bis 13.

Gemäß der vorliegenden Erfindung ist die strahlungsdurchlässige Chipumhüllung, vorzugsweise eine Kunststoffumhüllung, diffus streuend ausgebildet und enthält hierzu vorzugsweise Diffuserpartikel, das heißt strahlungsstreuende Partikel, an denen vom LED-Chip emittierte Strahlung gestreut wird. Von dem Halbleiterchip zur Seite hin emittierte Strahlen werden an den Diffuserpartikeln derart gestreut, dass sie zumindest zu einem großen Teil nicht mehr an den Seitenwänden der Ausnehmung des Grundkörpers und/oder, nach einer Reflexion an den Seitenwänden der Ausnehmung, an den Seitenflächen des Halbleiterchips absorbiert werden. Der Anteil der durch die Emissionsfläche des Bauelements nach vorne, das heißt im Wesentlichen in Richtung der optischen Achse austretenden Strahlung wird dadurch erhöht. Damit wird der Wirkungsgrad des Bauelements verbessert.

Der Gehalt an Diffusor in der Chipumhüllung ist derart bemessen, dass die Strahlung in Achsrichtung deutlich erhöht ist gegenüber einer gleichartigen Chipumhüllung ohne Diffusor. Besonders bevorzugt ist der Gehalt an Diffusor derart bemessen, dass die Strahlung in Achsrichtung deutlich erhöht ist und gleichzeitig die Gesamtlichtstrahlung nur unwesentlich reduziert ist.

Der Konzentrationsbereich ist vorzugsweise so bemessen, dass der Lichtgewinn in Achsrichtung größer ist als der durch die Diffusorpartikel (unter anderem durch Absorption an den Diffusorpartikeln) verursachte Gesamtlichtverlust im Bauelement.

Der Begriff Achsrichtung bezieht sich auf die optische Achse des LED-Chips.

Das Einbringen von Diffuserpartikeln ist dabei nicht auf das Ziel einer Aufweitung des Lichtabstrahlwinkels gerichtet, sondern bewirkt, dass vom Bauelement mehr Licht nach vorne emittiert wird und zugleich eine Projektion des Chips und des Bonddrahtes vermieden wird.

Bei einem Bauelement gemäß der vorliegenden Erfindung wird gegenüber an sich gleichen Bauelementen ohne Diffuserpartikel in der Chipumhüllung mehr Licht nach vorne ausgesandt. Offenbar ist die Streuung an den Diffuserpartikeln effektiver als die Reflexion an Seitenwänden der Ausnehmung des Grundkörpers, was durchaus als überraschend zu betrachten ist.

Dieser Effekt kommt ganz besonders bei Chips zum tragen, die zu einem wesentlichen Teil im Chip erzeugte elektromagnetische Strahlung über Chip-Seitenflächen, beispielsweise über Seitenflächen des Substrats, auf dem sich die epitaktisch hergestellte Halbleiterschichtenfolge befindet, emittieren. Solche LED-Chips werden im Folgenden als seitlich emittierende LED-Chips bezeichnet. Ganz besonders ist dies beispielsweise bei den in den Druckschriften WO 01/61764 und WO 01/61765 beschriebenen LED-Chips der Fall.

Solche LED-Chips, die im Weiteren mit "ATON" und ggf. einem nachgestellten Farbhinweis bezeichnet werden, sind dadurch charakterisiert, dass ein erheblicher Teil der im Chip erzeugten Strahlung über mindestens einen schräg, gekrümmt oder gestuft zur Haupterstreckungsrichtung einer strahlungserzeugenden Epitaxieschichtenfolge verlaufenden Seitenflächenbereich seitlich nach hinten und damit nicht in Abstrahlrichtung des Bauelements emittiert wird. Der Seitenflankenbereich ist dabei zur Chiprückseite hin geneigt. Die Diffuserpartikel in der Chipumhüllung bewirken insbesondere bei Bauelementen mit solchen LED-Chips überraschenderweise eine gegenüber derartigen Bauelmenten ohne Diffuserpartikel in der Chipumhüllung deutlich gesteigerte Strahlung nach vorne.

Außerdem wird die von den Halbleiterchips emittierte Strahlung durch die Diffuserpartikel gleichmäßig verteilt. Dies bewirkt einerseits, dass das Licht gleichmäßig durch die Emissionsfläche des Bauelements abgestrahlt wird, und andererseits, dass eine Projektion der Chipoberflächen sowie Verdrahtungen der LED-Chips vermieden wird.

Ein weiterer Vorteil der erfindungsgemäßen Maßnahme liegt darin, dass die Diffuserpartikel nicht nur auf das von den LED-Chips emittierte Licht wirken, sondern auch auf das von außen einfallende Fremdlicht. Im Gegensatz zu einer klaren Vergussmasse ohne Diffuserpartikel wird das Fremdlicht deshalb nicht zurückgespiegelt, sondern diffus reflektiert, so dass das Bauelement einen besseren Kontrast sicherstellt.

Ein besonderer Vorteil der Erfindung besteht unter anderem auch darin, dass das Kontrastverhalten von Bauelementen gemäß der Erfindung besser ist als bei herkömmlichen oberflächenemittierenden Bauelementen, was insbesondere hinsichtlich Displayanwendungen von großer Bedeutung ist. Überdies ist die Leuchtdichte von erfindungsgemäßen Bauelementen geringer, da die emittierende Fläche größer ist. Es emittiert die gesamte Fläche der mit Diffusorpartikeln versehenen Chipumhüllung. Ein weiterer Vorteil der Erfindung besteht darin, dass dadurch störende Reflexionen von Sonnenlicht am Bauelement verringert werden.

Der Anteil der Diffuserpartikel in der transparenten Vergussmasse beträgt vorzugsweise zwischen etwa 0,1% und 10%, besonders bevorzugt zwischen 0,15% und etwa 3,0%, ganz besonders bevorzugt zwischen etwa 0,75% und etwa 1,25%. Dies gilt insbesondere für Diffusorpartikel in Epoxidgießharz, vorzugsweise CaF-Diffusorpartikel.

Wie bei herkömmlichen optoelektronischen Bauelementen kann die transparente Vergussmasse ein Epoxidharz und der Grundkörper aus einem duroplastischen oder thermoplastischen Material hergestellt sein, so dass vorteilhafterweise herkömmliche Produktionsverfahren verwendet werden können.

Zur weiteren Verbesserung des Kontrasts bei der Lichtemission ist es vorteilhaft, den Grundkörper sowie die nach vorne gerichtete Oberfläche schwarz auszubilden.

Die obigen sowie weitere Merkmale und Vorteile der vorliegenden Erfindung werden anhand der folgenden Beschreibung bevorzugter Ausführungsbeispiele unter Bezugnahme auf die beiliegenden Zeichnungen (Figuren 1 bis 16) näher erläutert. Darin zeigen:
FIG 1 eine schematische Darstellung des Grundaufbaus eines optoelektronischen Bauelements gemäß der vorliegenden Erfindung im Schnitt;
FIG 2A bis 2D verschiedene bevorzugte Ausführungsformen von optoelektronischen Bauelementen gemäß der vorliegenden Erfindung in stark vereinfachter Darstellung;
FIG 3 ein Diagramm einer Abstrahlcharakteristik eines optoelektronischen Bauelements gemäß der vorliegenden Erfindung im Vergleich zu einem herkömmlichen Bauelement;
FIG 4A bis 4C tabellarische und graphische Darstellungen von Messergebnissen der Lichtstärke, die bei einer ersten Versuchsreihe an einem optoelektronischen Bauelement gemäß der vorliegenden Erfindung erzielt wurden;
FIG 5A bis 5C tabellarische und graphische Darstellungen von Messergebnissen des Lichtstroms, die bei der ersten Versuchsreihe an einem optoelektronischen Bauelement gemäß der vorliegenden Erfindung erzielt wurden;
FIG 6A bis 6C Diagramme der Abstrahlcharakteristiken für die verschiedenen LED-Chips, die bei der ersten Versuchsreihe an einem optoelektronischen Bauelement gemäß der vorliegenden Erfindung gemessen wurden;
FIG 7A bis 7C tabellarische und graphische Darstellungen von Messergebnissen der Lichtstärke, die bei einer zweiten Versuchsreihe an einem optoelektronischen Bauelement gemäß der vorliegenden Erfindung erzielt wurden;
FIG 8A bis 8C tabellarische und graphische Darstellungen von Messergebnissen des Lichtstroms, die bei der zweiten Versuchsreihe an einem optoelektronischen Bauelement gemäß der vorliegenden Erfindung erzielt wurden;
FIG 9A bis 9C Diagramme der Abstrahlcharakteristiken für die verschiedenen LED-Chips, die bei der zweiten Versuchsreihe an einem optoelektronischen Bauelement gemäß der vorliegenden Erfindung gemessen wurden;
FIG 10A bis 10C tabellarische und graphische Darstellungen von Messergebnissen der Lichtstärke, die bei einer dritten Versuchsreihe an einem optoelektronischen Bauelement gemäß der vorliegenden Erfindung erzielt wurden;
FIG 11A bis 11C tabellarische und graphische Darstellungen von Messergebnissen des Lichtstroms, die bei der dritten Versuchsreihe an einem optoelektronischen Bauelement gemäß der vorliegenden Erfindung erzielt wurden;
FIG 12 bis 15B schematische Darstellungen von verschiedenen Ausführungsformen herkömmlicher optoelektronischer Bauelemente; und
FIG 16 ein Diagramm, in dem die Helligkeit in Vorwärtsrichtung und die Gesamthelligkeit in Abhängigkeit vom Diffusorgehalt aufgetragen ist, für ein Bauelement mit CaF als Diffusormaterial in Epoxidharz-Chipverguß und einem InGaN-basieren LED-Chip in einem oberflächenmontierbaren LED-Gehäuse.

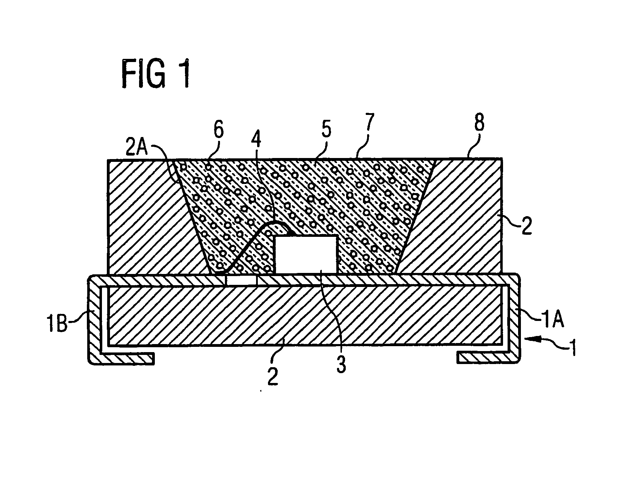

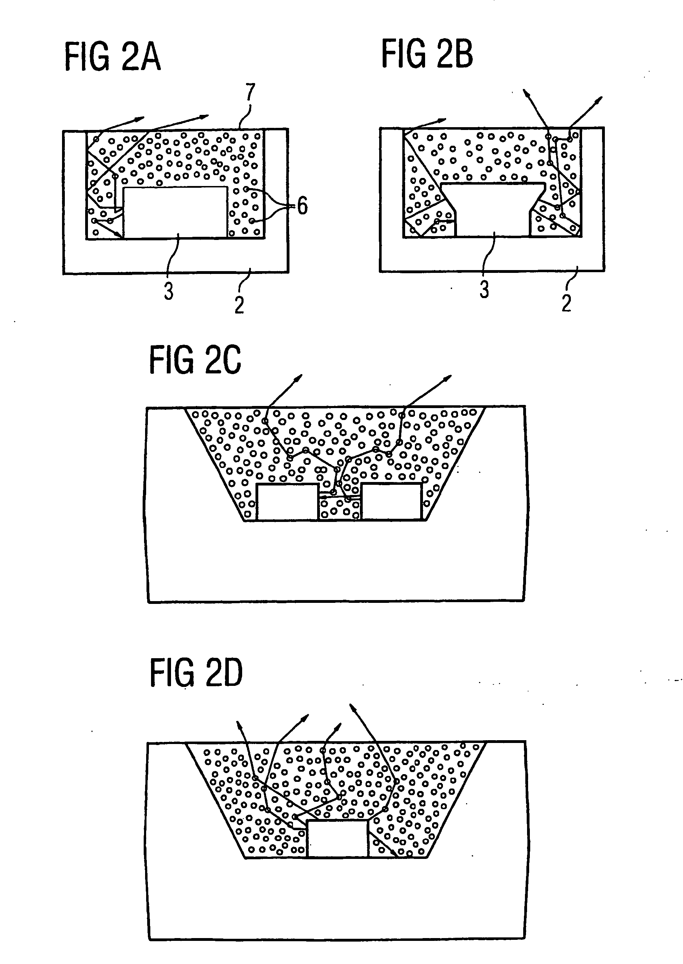

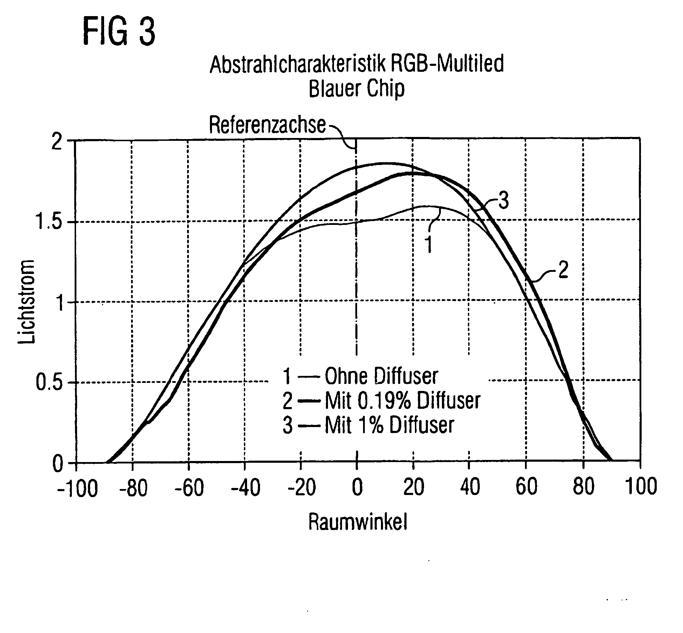

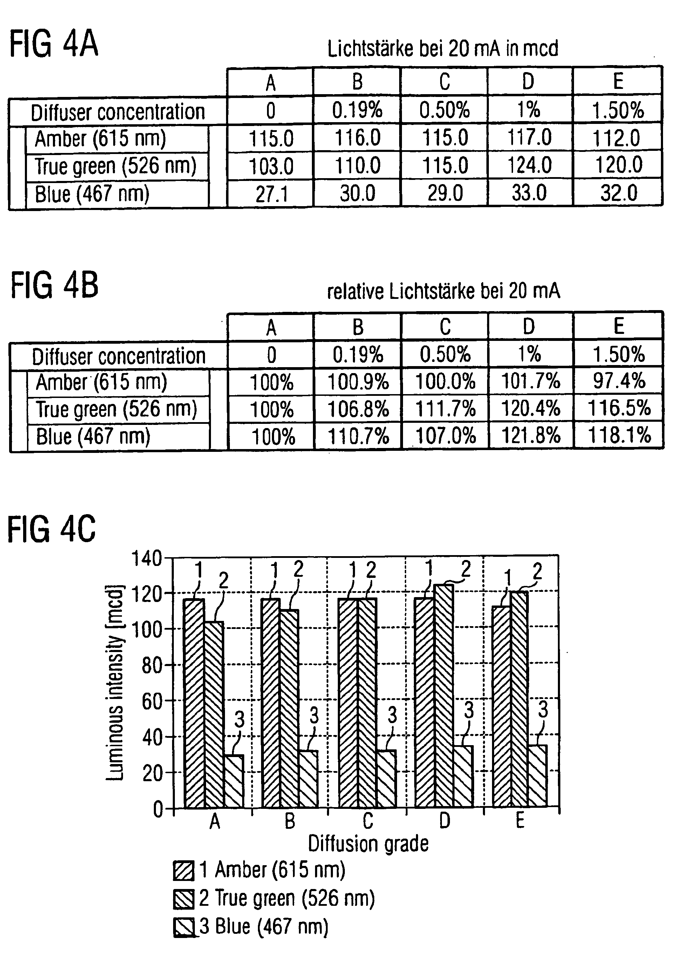

Zunächst wird anhand von FIG 1 der grundsätzliche Aufbau eines optoelektronischen Bauelements gemäß der vorliegenden Erfindung erläutert. Verschiedene mögliche Ausführungsformen des Bauelements und die erfindungsgemäße Wirkungsweise werden anschließend unter Bezug auf die FIG 2 und 3 beschrieben. Schließlich wurden von den Erfindern drei Versuchsreihen durchgeführt, deren Messergebnisse anhand der FIG 4 bis 11 dargestellt sind.

In FIG 1 ist eine schematische Querschnittsansicht eines oberflächenmontierbaren optoelektronischen Bauelements dargestellt, das gemäß der vorliegenden Erfindung ausgebildet ist. Der Grundkörper 2 für das Bauelement ist durch Umspritzen eines Leadframes 1 mit einem geeigneten Kunststoffmaterial unter Formung eines Gehäuses gebildet. Das Gehäuse 2 weist eine mittige Ausnehmung auf, in der ein Halbleiterchip 3 wie zum Beispiel ein optoelektronischer Senderchip angeordnet und mit den elektrischen Anschlüssen 1A, 1B des Leadframes 1 mittels Bonddrahttechnik 4 elektrisch leitend verbunden wird.

Die Innenflächen 2A der Ausnehmung des Grundkörpers 2 sind vorzugsweise schräg ausgebildet, wie dies in FIG 1 gezeigt ist. In einem besonderen Ausführungsbeispiel, das nich Teil dieser Erfindung ist, können durch die Auswahl eines geeigneten Materials für den Grundkörper 2 mit einem hohen Reflexionsvermögen diese schrägen Innenflächen 2A zudem als Reflektoren dienen, um die Abstrahlleistung bzw. die Empfangsempfindlichkeit des optoelektronischen Bauelements zu erhöhen.

Es sei an dieser Stelle darauf hingewiesen, dass die vorliegende Erfindung nicht nur auf die in den gezeigten Ausführungsbeispielen dargestellte Toplooker-Konstruktion (vgl. Beschreibungseinleitung) beschränkt ist. Insbesondere können natürlich auch Bauelemente mit Sidelooker-Konstruktion (vgl. Beschreibungseinleitung) unter Verwendung der erfindungsgemäßen Maßnahme aufgebaut sein.

Für den Grundkörper 2 des Bauelements wird beispielsweise ein Kunststoffmaterial, vorzugsweise ein thermoplastischer oder duroplastischer Kunststoff eingesetzt. Man hat in der Vergangenheit festgestellt, dass sich hierfür beispielsweise Polyphtalamid besonders eignet, welches zusätzlich mit Glasfasern versetzt werden kann.

Der optoelektronische Halbleiterchip 3 ist in einer Chipumhüllung 5, beispielsweise einer transparenten Vergussmasse eingebettet. Die dem Halbleiterchip 3 abgewandte Emissionsfläche oder Strahlungsauskoppelfläche 7 der Chipumhüllung 5 schließt dabei im wesentlichen mit der Oberfläche 8 des Grundkörpers 2 ab. Es wird aber darauf hingewiesen, dass im Rahmen der vorliegenden Erfindung je nach Bedarf selbstverständlich auch andere Füllhöhen der Chipumhüllung 5 in der Ausnehmung des Grundkörpers 2 gewählt sein können.

Als Material für die Chipumhüllung 5 wird üblicherweise ein transparentes Material eingesetzt, das vorzugsweise UVinitiiert oder Licht-initiiert kationisch härtende Eigenschaften besitzt. Ein bevorzugtes Material 5 enthält ein UVinitiiert oder Licht-initiiert kationisch härtendes Epoxidharz, das durch Beaufschlagung mit Licht- oder UV-Strahlung innerhalb weniger Sekunden angehärtet bzw. vorfixiert und zu einem späteren Zeitpunkt thermisch vollständig ausgehärtet werden kann. Geeignete Materialien sind aber beispielsweise auch Acrylharze (wie PMMA) oder Siliconharze.

Die Chipumhüllung 5 ist gemäß der vorliegenden Erfindung diffus streuend ausgebildet. Dies wird bevorzugt dadurch erreicht, dass die Chipumhüllung 5 Diffuserpartikel 6 enthält, die die auf sie treffende Strahlung, insbesondere Licht, diffus streuen.

Der Anteil der Diffuserpartikel in der transparenten Vergussmasse beträgt zwischen etwa 0,15% und etwa 2,0%, vorzugsweise zwischen etwa 0,75% und etwa 1,25%, und besonders bevorzugt etwa 1,0%. Der optimale Anteil der Diffuserpartikel hängt unter anderem von der Bauhöhe des Bauelements bzw. seiner Komponenten ab.

Es sei an dieser Stelle darauf hingewiesen, dass die vorliegende Erfindung auf keine speziellen Diffuserpartikel beschränkt ist. Der Fachmann auf dem Gebiet der Optoelektronik bzw. der Optik wird problemlos die für seine Zwecke geeigneten Diffuserpartikel herausfinden, deren Größe und Materialzusammensetzung unter anderem von der Wellenlänge der zu streuenden Strahlung abhängen kann. Die Wahl der geeigneten Diffuserpartikel wird insbesondere von der Wellenlänge des von den LED-Chips 3 emittierten oder zu empfangenden Lichts abhängen.

Außerdem kann die Chipumhüllung 5 je nach Wahl des Materials des Grundkörpers 2 und den gewünschten optischen Eigenschaften des optoelektronischen Bauelements neben seinem Hauptbestandteil des oben angegebenen Epoxidharzes und der Diffuserpartikel zusätzlich weitere Anteile enthalten, um die Verbindungsstärke mit dem Grundkörpermaterial, die Anhärte- und Aushärtezeit, die Lichtdurchlässigkeit, den Brechungsindex, die Temperaturbeständigkeit, die mechanische Härte, etc. wunschgemäß einzustellen.

Die FIG 2A bis 2D zeigen verschiedene Bauformen optoelektronischer Bauelemente, bei denen die erfindungsgemäße Ausgestaltung des Bauelements vorzugsweise eingesetzt werden kann.

So zeigt FIG 2A ein Bauelement mit einem hauptsächlich seitlich emittierenden LED-Chip 3 in einer engen Ausnehmung in dem Grundkörper 2. Die seitlich emittierte Strahlung wird zum Teil an den in der Chipumhüllung 5 vorhandenen Diffuserpartikeln 6 gestreut, so dass dieser Anteil der Strahlung nicht nach einer Reflexion an den Seitenwänden der Ausnehmung wieder von den Seitenflächen des LED-Chips 3 absorbiert wird. Auf diese Weise wird der Anteil des durch die Emissionsfläche 7 des Bauelements emittierten Strahlung im Vergleich zu herkömmlichen optoelektronischen Bauelementen größer, d.h. der Wirkungsgrad des Bauelements erhöht.

Das gleiche Prinzip gilt auch, wenn statt des lichtemittierenden LED-Chips 3 ein optoelektronischer Sensor zum Empfangen von Strahlung eingesetzt wird. Auch in diesem Fall wird der Wirkungsgrad des Bauelements erhöht, da aufgrund der Streuung der einfallenden Strahlung an den Diffuserpartikeln 6 ein größerer Anteil der einfallenden Strahlung von den Seitenflächen des Halbleiterchips empfangen werden kann.

Durch die Diffuserpartikel 6 in der Chipumhüllung 5 wird nicht nur der Wirkungsgrad des Bauelements erhöht, sondern das durch die Emissionsfläche abgestrahlte Licht ist gleichmäßiger über die gesamte Emissionsfläche 7 verteilt und verhindert zudem eine Projektion der Chipoberfläche oder der Verdrahtungen 4.

Durch die diffuse Streuung des von dem LED-Chip 3 emittierten Lichts wird außerdem die Abstrahlcharakteristik des LED-Chips zentriert, selbst wenn sie beispielsweise aufgrund des Einbaus mehrerer LED-Chips 3 in dem Bauelement ohne die Diffuserpartikel dezentriert wäre. Dies ist in dem Diagramm von FIG 3 veranschaulicht. Während die mit 1 bezeichnete Kurve die Abstrahlcharakteristik eines herkömmlichen blauen LED-Chips 3 zeigt, der in der Darstellung von FIG 3 nach rechts dezentriert ist, wird die Abstrahlcharakteristik mit zunehmendem Anteil von Diffuserpartikeln auf bis zu 1% besser zentriert, wie dies durch die beiden Kurven 2 und 3 angegeben ist. Der zudem höhere Messwert des Lichtstroms bei den Kurven 2 und 3 resultiert aus dem Umstand, dass die Messung bezogen auf die Referenzachse erfolgte.

Ein weiterer Vorteil der Diffuserpartikel 6 in der Chipumhüllung 5 zeigt sich insbesondere in dem Anwendungsgebiet der Anzeigen- oder Displaytechnik, wo der Fremdlichteinfall für eine klare und deutliche Anzeige von Informationen grundsätzlich ein Problem darstellt. Im Gegensatz zu einem klaren Harz als Vergussmasse 5 wird das einfallende Fremdlicht nicht gespiegelt, sondern wegen der Diffuserpartikel 6 diffus reflektiert. Dadurch verliert das Fremdlicht an Stärke, was zu einem besseren Kontrast der Anzeige selbst bei Fremdlichteinfall führt.

In FIG 2B ist ein optoelektronisches Bauelement mit einem LED-Chip 3 dargestellt, bei dem ein großer Anteil des emittierten Lichts von den Chipflanken aus schräg nach hinten, das heißt in Richtung Gehäuseinneres abgestrahlt wird. Hervorgerufen wird dies durch in Bezug auf die Haupterstrekkungsrichtung der Epitaxieschichtenfolge schräg, gekrümmt oder gestuft nach Innen verlaufende Flankenbereiche, wie es in der Figur 2B angbedeutet ist. Solche LED-Chips 3, die im Weiteren mit "ATON" und ggf. einem Farbhinweis bezeichnet werden, sind beispielsweise in den Druckschriften WO 01/61764 und WO 01/61765 beschrieben. Im Gegensatz zu herkömmlichen Konzepten von Bauelement-Gehäusen, die wesentlich auf Reflexion an den Innenwänden der Ausnehmung basieren, wird hier das emittierte Licht an den in der Chipumhüllung verteilten Diffuserpartikeln gestreut und zur Bauelement-Vorderseite umgelenkt. Dies führt zu den bereits genannten Vorteilen (vgl. Beschreibungseinleitung und Beschreibung der Ausführungsform gemäß FIG 2A). Bei einem Bauelement gemäß FIG 2B kommt der vorteilhafte Effekt der erfindungsgemäßen Ausgestaltung der Chipumhüllung ganz besonders zum Tragen.

FIG 2C zeigt ein Bauelement mit mehreren LED-Chips 3, wie dies zum Beispiel zum Aufbau eines Mehrfarben-LED-Bauelements benutzt wird. Bei herkömmlichen Bauelementen werden in diesem Fall bis zu 30% des von den LED-Chips 3 emittierten Lichts von anderen LED-Chips und den steilen Seitenwänden der Ausnehmung absorbiert. Durch die erfindungsgemäß vorgesehenen Diffuserpartikel 6 kann das Licht vor dem Auftreffen auf die Seitenflächen der benachbarten LED-Chips und die Seitenwände der Ausnehmung abgelenkt werden und so das Bauelement durch die Emissionsfläche 7 verlassen.

Schließlich ist in FIG 2D ein Bauelement mit einem dunklen bzw, schwarzen Grundkörper 2 gezeigt. Auch hier wird das Licht vor dem Auftreffen auf die schwarzen Seitenwände der Ausnehmung durch die Diffuserpartikel 6 in der Vergussmasse 5 abgelenkt und gelangt zu der Emissionsfläche 7 des Bauelements.

Bei allen gezeigten Ausführungsbeispielen treten selbstverständlich alle genannten Vorteile, wie insbesondere höherer Wirkungsgrad, gleichmäßigere Lichtemission, zentrierte Abstrahlcharakteriotik, Vermeidung der Projektion von Chipoberflächen und besserer Kontrast, auf, auch wenn diese nicht bei allen gezeigten Ausführungsbeispielen nochmals wiederholt wurden.

Nachfolgend werden nun insgesamt drei Versuchsreihen beschrieben, die an optoelektronischen Bauelementen durchgeführt wurden, die gemäß der vorliegenden Erfindung aufgebaut waren.

### 1. Versuchsreihe

Bei der ersten Versuchsreihe wurde ein dreifarbiges LED-Bauelement (auch als RGB(Rot Grün Blau)-Multiled bezeichnet) vermessen, das in der Draufsicht etwa der Darstellung von FIG 15B entspricht, und das einen vollständig schwarzen Grundkörper aufweist. Die drei LED-Chips emittieren Strahlung im orangenen ("HOP amber") Wellenlängenbereich von etwa 615 nm, im grünen ("ATON true green") Wellenlängenbereich von etwa 526 nm bzw. im blauen ("ATON blue") Wellenlängenbereich von etwa 467 nm.

Die in FIG 4A dargestellte Tabelle zeigt die bei einem Diodenstrom von 20 mA gemessenen Lichtstärken in mcd (10⁻³ Candela) für verschiedene Konzentrationen bzw. Anteile von Diffuserpartikeln in der Vergussmasse von 0,19%, 0,50%, 1,0% und 1,50%. Zum Vergleich ist außerdem der Messwert für ein herkömmliches Bauelement mit einer Vergussmasse ohne Diffuserpartikel (Anteil 0%) angegeben. Die gleichen Messwerte sind nochmals in dem Balkendiagramm von FIG 4C veranschaulicht.

Darüber hinaus sind in der Tabelle von FIG 4B die relativen Lichtstärken bezogen auf 100% für eine Vergussmasse ohne Diffuserpartikel dargestellt. Wie angegeben, konnte durch die Erfindung eine Steigerung der Lichtstärke um bis zu 21,8% erzielt werden (Diffuseranteil 1,0%, blaue LED).

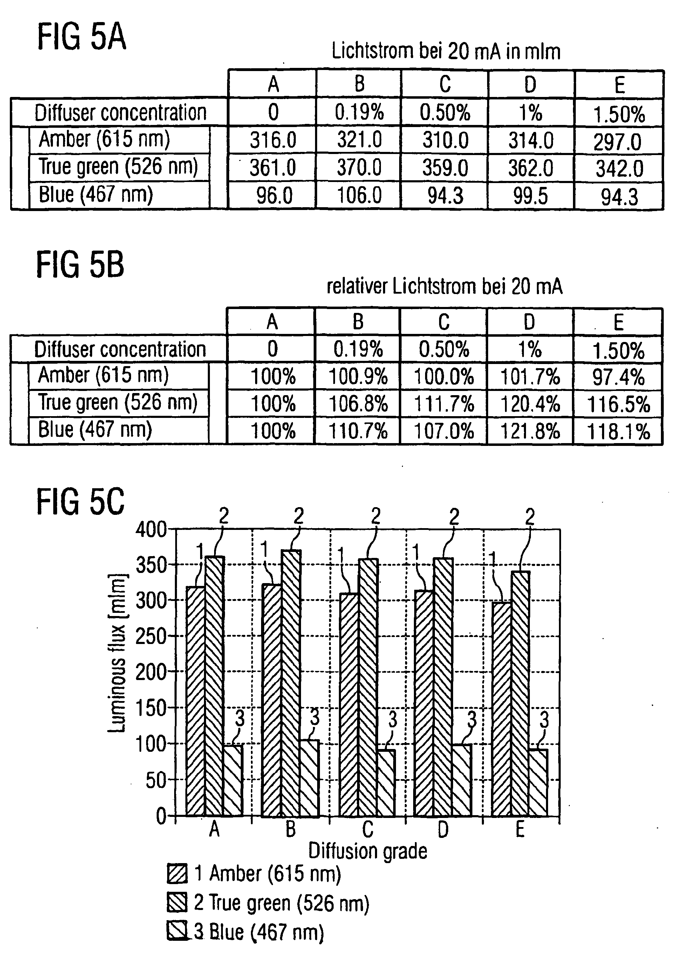

Die FIG 5A bis 5C zeigen die Ergebnisse der gleichen Versuchsreihe, wobei hier jeweils statt der Lichtstärke der Lichtstrom in mlm (10⁻³ Lumen) bzw. der relative Lichtstrom angegeben bzw. aufgetragen ist.

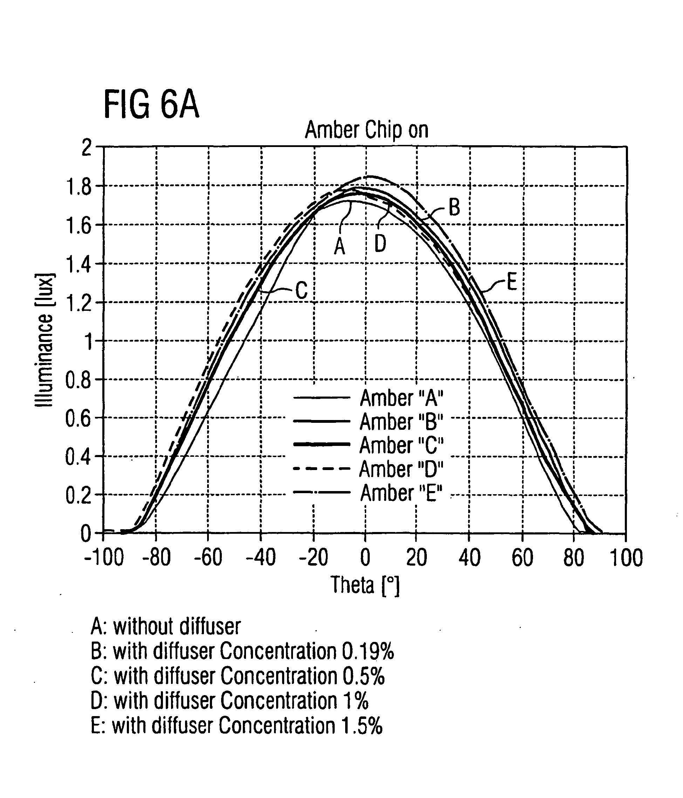

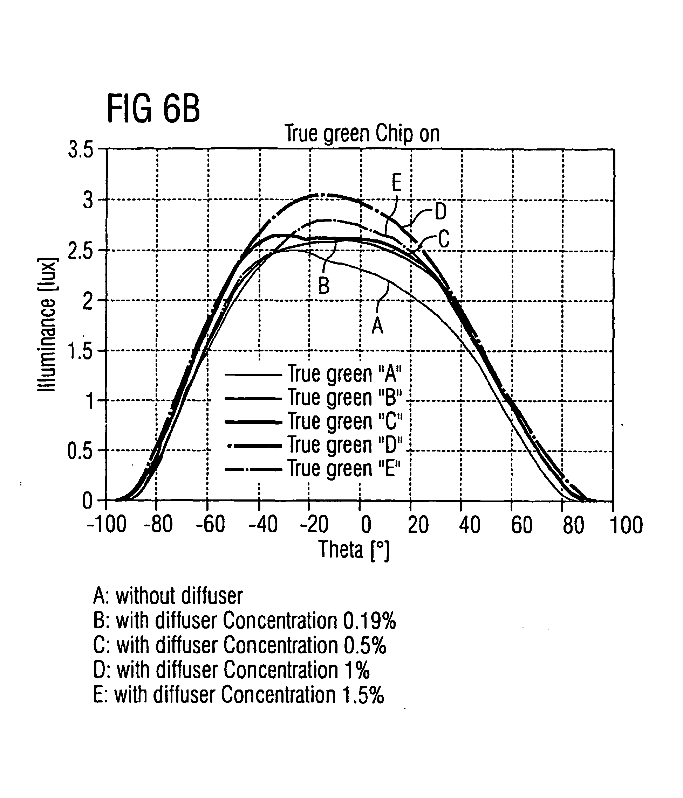

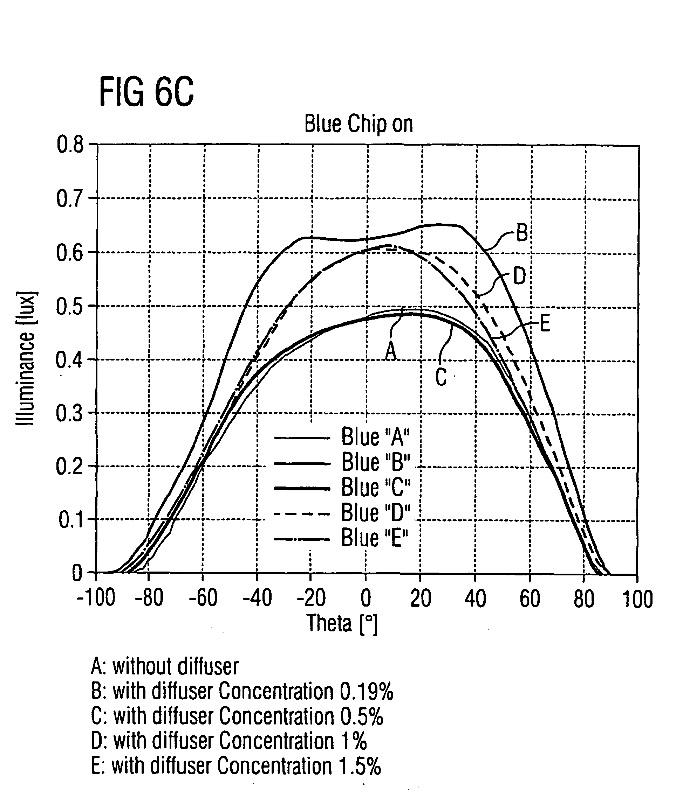

Schließlich zeigen die FIG 6A bis 6C jeweils die Abstrahlcharakteristik des orangenen, des grünen bzw. des blauen LED-Chips 3 für die verschiedenen Anteile der Diffuserpartikel in der Vergussmasse. Wie deutlich zu erkennen, ergibt sich durch den Anteil der Diffuserpartikel eine gleichmäßigere und zentriertere Abstrahlcharakteristik als bei einer Vergussmasse ohne diffus streuende Eigenschaften. Ferner ist zu erkennen, dass sich bei einem Anteil von etwa 1% Diffuserpartikeln die besten Ergebnisse bezüglich der Abstrahlcharakteristik erzielen lassen. Außerdem sieht man, dass die Vorteile bei den Chips mit hauptsächlich seitlicher Abstrahlung ("ATON") besonders deutlich ausfallen.

### 2. Versuchsreihe

Bei der zweiten Versuchsreihe wurde ebenfalls ein dreifarbiges RGB-Multiled vermessen, das aber im Gegensatz zu der ersten Versuchsreihe mit einem weißen Grundkörper versehen war. Die drei LED-Chips emittierten Strahlung wiederum im orangenen ("HOP amber") Wellenlängenbereich von etwa 614 nm, im grünen ("ATON true green") Wellenlängenbereich von etwa 532 nm bzw. im blauen ("ATON blue") Wellenlängenbereich von etwa 465 nm.

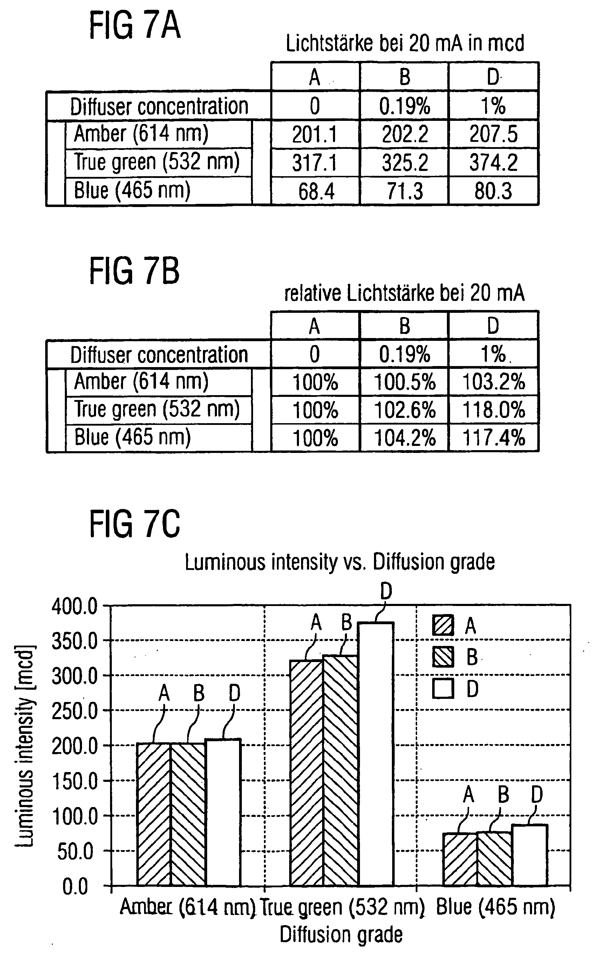

Die in FIG 7A dargestellte Tabelle zeigt die bei einem Diodenstrom von 20 mA gemessenen Lichtstärken in mcd für die verschiedenen Konzentrationen von Diffuserpartikeln in der Vergussmasse zwischen 0% und 1,0%. Die gleichen Messwerte sind auch in dem Balkendiagramm von FIG 7C veranschaulicht.

Die Tabelle von FIG 7B zeigt die relativen Lichtstärken bezogen auf 100% für eine Vergussmasse ohne Diffuserpartikel. Wie dargestellt, konnte durch die Erfindung bei diesem Versuchsaufbau eine Steigerung der Lichtstärke um bis zu 18% erzielt werden (Diffuseranteil 1,0%, grüne LED).

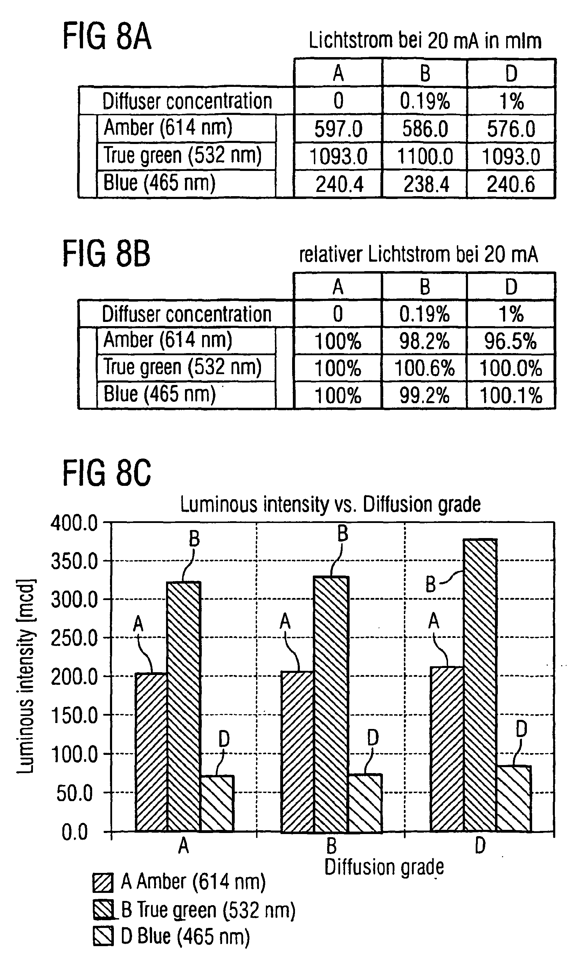

Die FIG 8A bis 8C zeigen die Ergebnisse der gleichen Versuchsreihe, wobei hier jeweils statt der Lichtstärke der Lichtstrom in mlm bzw. der relative Lichtstrom angegeben bzw. aufgetragen ist.

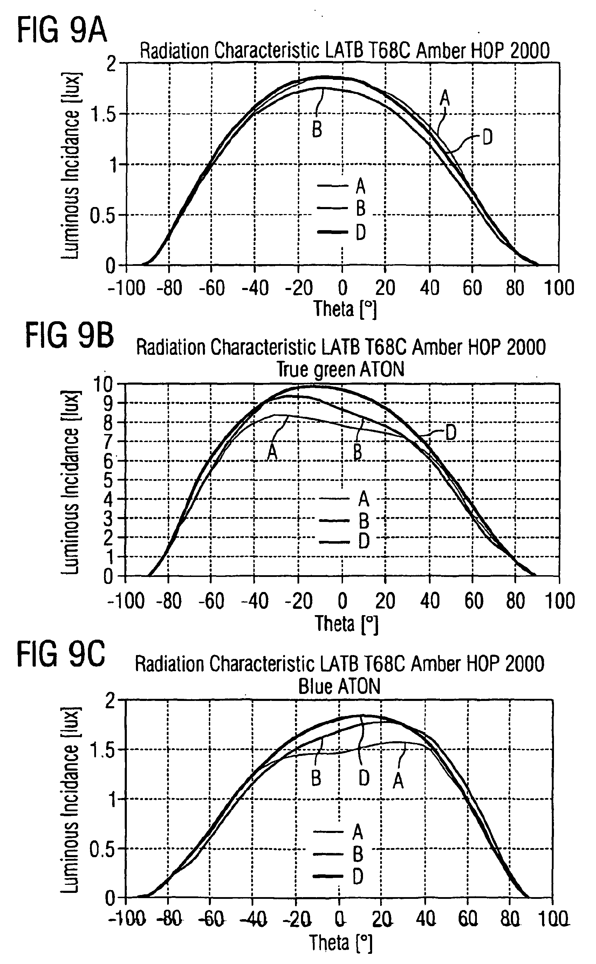

Schließlich zeigen die FIG 9A bis 9C die stufenweise Verbesserung der jeweiligen Abstrahlcharakteristik des orangenen, des grünen bzw. des blauen LED-Chips 3 aufgrund der erhöhten Anteile der Diffuserpartikel in der Vergussmasse.

### 3. Versuchsreihe

Bei der dritten Versuchsreihe wurden schließlich optoelektronische Bauelemente gemäß der vorliegenden Erfindung mit einzelnen blauen ("ATON blue") LED-Chips untersucht. Hierbei wurden sogenannte TOPLEDs und mini TOPLEDs mit einem Anteil von etwa 1% Diffuserpartikel in der Vergussmasse mit entsprechenden Bauelementen ohne Diffuserpartikel in der Vergussmasse verglichen.

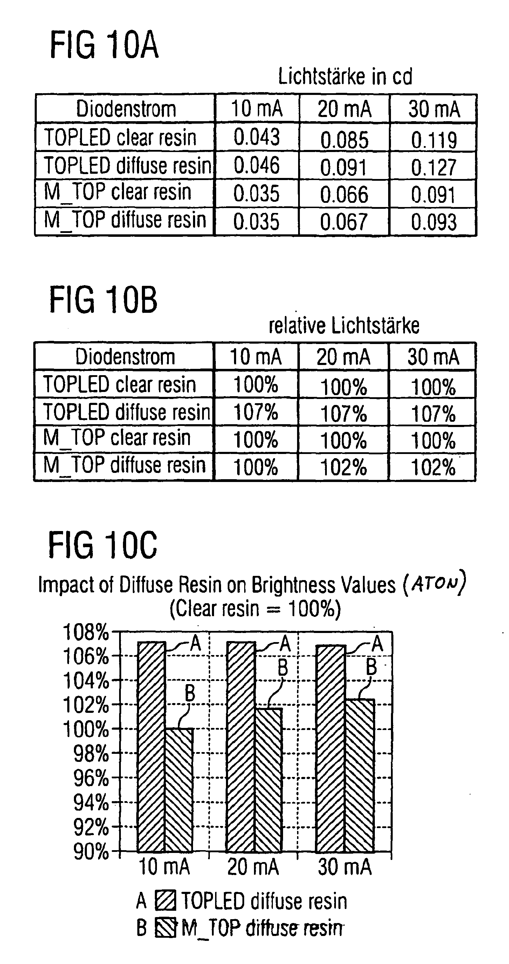

Die Tabelle von FIG 10A zeigt die bei Diodenströmen von 10 mA, 20 mA und 30 mA gemessenen Lichtstärken in cd (Candela), und die Tabelle von FIG 10B zeigt die bei Diodenströmen von 10 mA, 20 mA und 30 mA gemessenen relativen Lichtstärken in Bezug auf die Bauelemente mit einer Vergussmasse ohne Diffuserpartikel (100%). Die Messwerte der Lichtstärken sind auch in dem Balkendiagramm von FIG 10C veranschaulicht.

Bei den mini TOPLEDs konnten durch die diffus streuende Vergussmasse Steigerungen von 2% in der Lichtstärke erzielt werden, während bei den TOPLEDs sogar Steigerungen von bis zu 7% erreicht wurden.

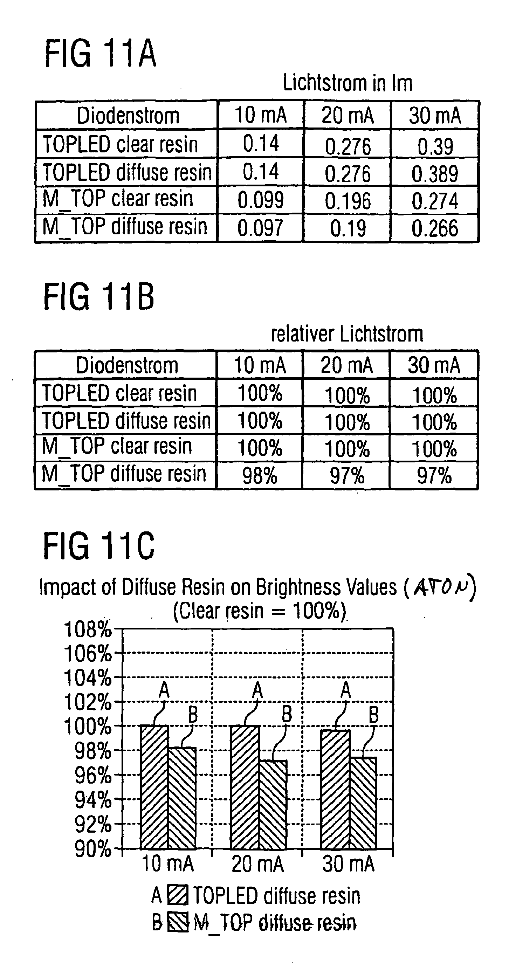

Die FIG 11A bis 11C zeigen nochmals die Ergebnisse der gleichen Versuchsreihe, wobei hier jeweils statt der Lichtstärke der Lichtstrom in lm (Lumen) bzw. der relative Lichtstrom angegeben bzw. aufgetragen ist.

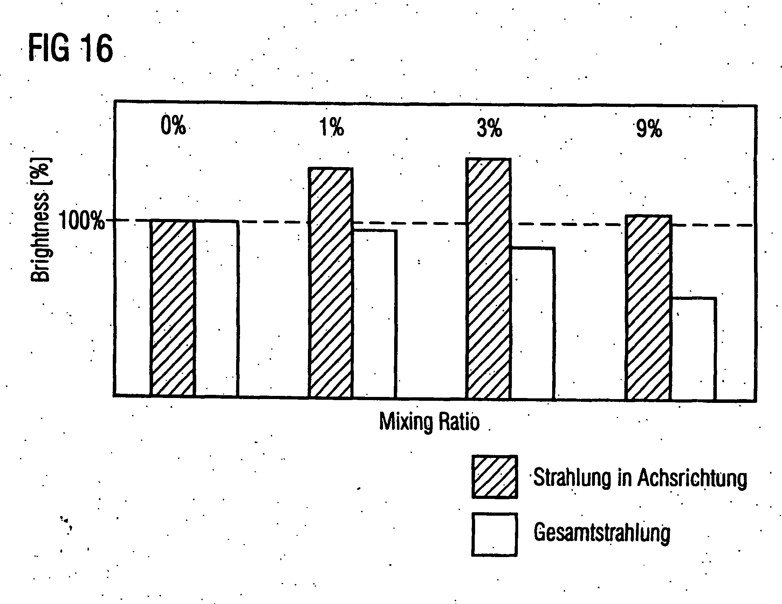

Aus dem in FIG 16 dargestellten Diagramm ist ersichtlich, dass zunächst mit zunehmendem Diffusorgehalt die Lichtstrahlung in Achsrichtung zunimmt ohne dass gleichzeitig die Gesamtlichtstrahlung drastisch abnimmt, bevor dann mit weiter zunehmendem Diffusorgehalt die Gesamtlichtstrahlung und auch die Vorwärtsstrahlung wieder abnimmt. In dem Diagramm sind vier Balkenpaare für vier verschiedene Konzentrationen von Diffuserpartikeln in der Vergussmasse aufgetragen, von denen jeweils der linke Balken die Helligkeit in Vorwärtsrichtung (oder Achsrichtung) und jeweils der rechte Balken die Gesamtlichtstrahlung repräsentiert. Es sind Balkenpaare für vier verschiedene Konzentrationen dargestellt, und zwar für 0%, 1%, 3% und 9% Diffusoranteil in der Vergußmasse. Die jeweils zu den Balkenpaaren gehörige Konzentration von Diffusorpartikeln ist jeweils über den Balkenpaaren angegeben. Als Bezug sind die ermittelten Werte für 0% Diffusorgehalt verwendet. Die Meßwerte wurden an einem Leuchtdiodenbauelement gemäß Figur 1 ermittelt. Der LED-Chip war ein InGaN-basierter LED-Chip mit SiC-Substrat, der einen wesentlichen Anteil der im Chip erzeugten Strahlung über die Chipflanken emittiert. Das Diffusormaterial war CaF. Es ist erkennbar, dass ein Maximum an Vorwärtsstrahlung bei ca. 3% Diffusoranteil in der Vergußmasse liegt. Eine deutliche Steigerung der Vorwärtsstrahlung bei gleichzeitig nahezu vernachlässigbarer Einbuße an Gesamtlichtleistung ergibt sich bei einem Diffusoranteil um 1%.

Die Leuchtdiodenbauelemente mit einem erfindungsgemäßen Diffusoranteil im Chipverguß weisen gegenüber gleichartigen Leuchtdiodenbauelementen ohne Diffusor ein deutlich verbessertes Kontrastverhalten auf. Überdies ist bei den erfindungsgemäßen Leuchtdiodenbauelementen eine Projektion des LED-Chips und ggf. von Bonddrähten je nach Diffusorgehalt vorteilhafterweise deutlich reduziert. Die Lichtabstrahlung erfolgt über die gesamte Vorderseite des Chipvergusses.

An dieser Stelle sei allgemein angemerkt, dass in der Vergußmasse enthaltene lichtstreuende Leuchtstoffpartikel, wie sie beispielsweise in weißes Licht emittierenden Leuchtdiodenbauelementen auf Basis von blaues Licht emittierenden LED-Chips angewendet werden, gleichzeitig als Diffusorpartikel wirken können und damit zumindest zum Teil den erfindungsgemäßen Effekt hervorrufen oder unterstützen können.

Weiterhin wurde festgestellt, dass die Beimischung von Diffusorpartikeln in eine Leuchtstoffpartikel enthaltende Vergußmasse, wie sie beispielsweise für oben erwähnte weißes Licht emittierende Leuchtdiodenbauelemente Anwendung finden, eine Steigerung der Lichtstrahlung in Achsrichtung hervorrufen kann. Ausschlaggebend ist hierbei, dass die Diffusorpartikel in einer geeigneten Konzentration der Vergußmasse beigemischt sind.

Der Vollständigkeit halber sei auch noch angemerkt, dass unter den Begriff Vergußmasse nicht nur solche Chipumhüllungsmassen zu verstehen sind, die mittels Gießtechnik verarbeitet werden, sondern dass darunter auch solche Chipumhüllungsmassen fallen, die mittels anderweitiger Technik, wie Spritzgießen oder Spritzpressen, auf den Chip aufgebracht werden.

## Patentansprüche

1. Optoelektronisches Bauelement mit einem strahlungsemittierenden Halbleiterchip (3), wobei
- der Halbleiterchip (3) in einer Ausnehmung eines Grundkörpers bzw. Gehäuses (2) angeordnet ist,
- der Grundkörper bzw. das Gehäuse (2) aus einem Material hergestellt ist, das für die vom Halbleiterchip (3) emittierte Strahlung zumindest teilweise absorbierend ist,
wobei der Grundkörper bzw. das Gehäuse (2) sowie die Seitenwände (2A) der Ausnehmung schwarz ausgebildet sind,
- der Halbleiterchip (3) in der Ausnehmung zumindest teilweise in einer Chipumhüllung (5) eingebettet ist, die für die vom Halbleiterchip (3) emittierte Strahlung durchlässig ist, und
- die Chipumhüllung (5) derart diffus streuend ausgebildet ist, dass eine vom Halbleiterchip (3) seitlich zum Grundkörper bzw. Gehäuse (2) hin ausgesandte Strahlung zu einer Strahlungsauskoppelfläche (7) der Chipumhüllung (5) hin umgelenkt wird, bevor sie auf die schwarzen Seitenwande (2A) der Ansnehmung des Grundkörpers bzw. Gehäuses (2) trifft.

2. Optoelektronisches Bauelement nach Anspruch 1,
**dadurch gekennzeichnet, dass**
die Chipumhüllung (5) strahlungsstreuende Partikel (6) enthält, an denen vom Halbleiterchip (3) erzeugte Strahlung gestreut wird.

3. Optoelektronisches Bauelement nach Anspruch 2,
**dadurch gekennzeichnet, dass**
der Anteil der strahlungsstreuenden Partikel (6) in der Chipumhüllung (5) zwischen 0,1% und 10% beträgt.

4. Optoelektronisches Bauelement nach Anspruch 3,
**dadurch gekennzeichnet, dass**
der Anteil der strahlungsstreuenden Partikel (6) in der Chipumhüllung (5) zwischen 0,15% und 3,0% beträgt.

5. Optoelektronisches Bauelement nach Anspruch 4,
**dadurch gekennzeichnet, dass**
der Anteil der strahlungsstreuenden Partikel (6) in der Chipumhüllung (5) zwischen 0,75% und 1,25% beträgt.

6. Optoelektronisches Bauelement nach einem der vorhergehenden Ansprüche,
**dadurch gekennzeichnet, dass**
die Chipumhüllung (5) ein Reaktionsharz, insbesondere ein Epoxidharz, ein Acrylharz oder ein Siliconharz aufweist.

7. Optoelektronisches Bauelement nach einem der vorhergehenden Ansprüche,
**dadurch gekennzeichnet, dass**
die Seitenwände (2A) der Ausnehmung in dem Grundkörper (2) schräg ausgebildet sind.

8. Optoelektronisches Bauelement nach einem der vorhergehenden Ansprüche,
**dadurch gekennzeichnet, dass**
der Grundkörper bzw. das Gehäuse (2) aus einem duroplastischen oder thermoplastischen Material hergestellt ist.

9. Optoelektronisches Bauelement nach einem der vorhergehenden Ansprüche,
**dadurch gekennzeichnet, dass**
in der Ausnehmung eine Mehrzahl von Halbleiterchips (3) nebeneinander angeordnet sind.

10. Optoelektronisches Bauelement nach Anspruch 9,
**dadurch gekennzeichnet, dass**
die Halbleiterchips (3) jeweils Strahlung von nur einer spektralen Farbe aussenden und die verschiedenen Halbleiterchips (3) Strahlung unterschiedlicher Farben aussenden.

11. Optoelektronisches Bauelement nach einem der vorhergehenden Ansprüche,
**dadurch gekennzeichnet, dass**
der Halbleiterchip (3) bzw. mindestens einer der Halbleiterchips (3) mindestens einen Seitenflankenbereich aufweist, durch den ein Teil der im Halbleiterchip (3) erzeugten Strahlung seitlich oder nach hinten in Richtung Grundkörper (2) emittiert wird.

12. Optoelektronisches Bauelement nach Anspruch 11,
**dadurch gekennzeichnet, dass**
der Seitenflankenbereich zur Haupterstreckungsrichtung einer epitaktisch hergestellten strahlungserzeugenden Halbleiterschichtenfolge schräg, gekrümmt oder gestuft verläuft.

13. Optoelektronisches Bauelement nach einem der vorhergehenden Ansprüche,
**dadurch gekennzeichnet, dass**
die Chipumhüllung (5) eine Kunststoffmasse ist.

## Claims

1. Optoelectronic component having a radiation-emitting semiconductor chip (3), wherein
- the semi-conductor chip (3) is arranged in a recess of a basic body or housing (2),
- the basic body or the housing (2) is produced from a material which is at least partly absorbent with respect to the radiation emitted by the semiconductor chip (3), the basic body or the housing (2) and the sidewalls (2A) of the recess being formed black,
- the semiconductor chip (3) is embedded in the recess at least partly in a chip encapsulation (5), which is transmissive with respect to the radiation emitted by the semiconductor chip (3), and
- the chip encapsulation (5) is formed in diffusely scattering fashion such that a radiation emitted sideways toward the basic body or housing (2) by the semiconductor chip (3) is deflected toward a radiation coupling-out area (7) of the chip encapsulation (5) before it impinges on the black sidewalls (2A) of the recess of the basic body or housing (2).

2. Optoelectronic component according to Claim 1,
**characterized in that**
the chip encapsulation (5) contains radiation-scattering particles (6) at which radiation generated by the semiconductor chip (3) is scattered.

3. Optoelectronic component according to Claim 2,
**characterized in that**
the proportion of radiation-scattering particles (6) in the chip encapsulation (5) is between 0.1% and 10%.

4. Optoelectronic component according to Claim 3,
**characterized in that**
the proportion of radiation-scattering particles (6) in the chip encapsulation (5) is between 0.15% and 3.0%.

5. Optoelectronic component according to Claim 4,
**characterized in that**
the proportion of radiation-scattering particles (6) in the chip encapsulation (5) is between 0.75% and 1.25%.

6. Optoelectronic component according to one of the preceding claims,
**characterized in that**
the chip encapsulation (5) has a reaction resin, in particular an epoxy resin, an acrylic resin or a silicon resin.

7. Optoelectronic component according to one of the preceding claims,
**characterized in that**
the sidewalls (2A) of the recess in the basic body (2) are formed obliquely.

8. Optoelectronic component according to one of the preceding claims,
**characterized in that**
the basic body or the housing (2) is produced from a thermosetting plastic or thermoplastic material.

9. Optoelectronic component according to one of the preceding claims,
**characterized in that**
a plurality of semiconductor chips (3) are arranged next to one another in the recess.

10. Optoelectronic component according to Claim 9,
**characterized in that**
the semiconductor chips (3) in each case emit radiation of only one spectral color and the various semiconductor chips (3) emit radiation of different colors.

11. Optoelectronic component according to one of the preceding claims,
**characterized in that**
the semiconductor chip (3) or at least one of the semiconductor chips (3) has at least one sidewall region through which part of the radiation generated in the semiconductor chip (3) is emitted sideways or rearward in the direction of the basic body (2).

12. Optoelectronic component according to Claim 11,
**characterized in that**
the sidewall region runs obliquely, in curved fashion or in stepped fashion with respect to the main direction of extent of a radiation-generating semiconductor layer sequence produced epitaxially.

13. Optoelectronic component according to one of the preceding claims,
**characterized in that**
the chip encapsulation (5) is a plastics compound.

## Revendications

1. Composant optoélectronique comprenant une puce à semiconducteurs (3) émettant des rayonnements, dans lequel :
- la puce à semiconducteurs (3) est disposée dans un évidement d'un corps de base ou d'un boîtier (2),
- le corps de base ou le boîtier (2) est fabriqué en un matériau absorbant au moins en partie le rayonnement émis par la puce à semiconducteurs (3), le corps de base ou le boîtier (2) ainsi que les parois latérales (2A) de l'évidement étant noirs,
- la puce à semiconducteurs (3) dans l'évidement est noyée au moins en partie dans une gaine de puce (5) qui est perméable au rayonnement émis par la puce à semiconducteurs (3), et
- la gaine de puce (5) est réalisée de manière à disperser de manière diffuse de telle sorte qu'un rayonnement émis depuis la puce à semiconducteurs (3) latéralement en direction du corps de base ou du boîtier (2) soit dévié vers une surface de sortie de rayonnement (7) de la gaine de puce (5), avant d'arriver sur les parois latérales noires (2A) de l'évidement du corps de base ou du boîtier (2).

2. Composant optoélectronique selon la revendication 1, **caractérisé en ce que** la gaine de puce (5) contient des particules (6) diffusant le rayonnement, au niveau desquelles le rayonnement produit par la puce à semiconducteurs (3) est diffusé.

3. Composant optoélectronique selon la revendication 2, **caractérisé en ce que** la proportion des particules (6) diffusant le rayonnement dans la gaine de puce (5) est comprise entre 0,1 % et 10 %.

4. Composant optoélectronique selon la revendication 3, **caractérisé en ce que** la proportion des particules (6) diffusant le rayonnement dans la gaine de puce (5) est comprise entre 0,15 % et 3 %.

5. Composant optoélectronique selon la revendication 4, **caractérisé en ce que** la proportion des particules (6) diffusant le rayonnement dans la gaine de puce (5) est comprise entre 0,75 % et 1,25 %.

6. Composant optoélectronique selon l'une quelconque des revendications précédentes, **caractérisé en ce que** la gaine de puce (5) présente une résine de réaction, notamment une résine époxy, une résine acrylique ou une résine de silicone.

7. Composant optoélectronique selon l'une quelconque des revendications précédentes, **caractérisé en ce que** les parois latérales (2A) de l'évidement sont réalisées obliquement dans le corps de base (2).

8. Composant optoélectronique selon l'une quelconque des revendications précédentes, **caractérisé en ce que** le corps de base ou le boîtier (2) est fabriqué à partir d'un matériau duroplastique ou thermoplastique.

9. Composant optoélectronique selon l'une quelconque des revendications précédentes, **caractérisé en ce qu'**une pluralité de puces à semiconducteurs (3) sont disposées les unes à côté des autres dans l'évidement.

10. Composant optoélectronique selon la revendication 9, **caractérisé en ce que** les puces à semiconducteurs (3) émettent à chaque fois un rayonnement d'une seule couleur spectrale et les différentes puces à semiconducteurs (3) émettent rayonnement de couleurs différentes.

11. Composant optoélectronique selon l'une quelconque des revendications précédentes, **caractérisé en ce que** la puce à semiconducteurs (3) ou au moins une des puces à semiconducteurs (3) présente au moins une région de flanc latéral, à travers laquelle une partie du rayonnement produit dans la puce à semiconducteurs (3) est émise latéralement ou vers l'arrière dans la direction du corps de base (2).

12. Composant optoélectronique selon la revendication 11, **caractérisé en ce que** la région de flanc latéral s'étend sous forme oblique, courbe ou étagée par rapport à la direction d'étendue principale d'une succession de couches semiconductrices produisant un rayonnement et de construction épitactique.

13. Composant optoélectronique selon l'une quelconque des revendications précédentes, **caractérisé en ce que** la gaine de puce (5) est une composition de plastique.
